# EUROPEAN PATENT SPECIFICATION

(11) **EP 3 443 600 B1**
(45) Date of publication and mention of the grant of the patent: **21.04.2021**
(21) Application number: 16898079.5
(22) Date of filing: 07.04.2016
(51) Int. Cl.: H01L 41/053, H01L 41/083, H02N 2/02

(54) **DISPLACEMENT CONNECTORS OF HIGH BENDING STIFFNESS AND PIEZOELECTRIC ACTUATORS INCLUDING SUCH**
HUBVERBINDER MIT HOHER BIEGESTEIFIGKEIT UND PIEZOELEKTRISCHE AKTOREN DAMIT
CONNECTEURS DE DÉPLACEMENT À RIGIDITÉ ÉLEVÉE À LA FLEXION ET ACTIONNEURS PIÉZOÉLECTRIQUES INCLUANT CEUX-CI

(43) Date of publication of application: 20.02.2019
(73) Proprietor: Microfine Materials Technologies Pte Ltd, Singapore 658079 (SG)
(72) Inventor: LIM, Leong Chew, Singapore 596741 (SG); HUANG, Yu, Singapore 554478 (SG); XIA, Yuexue, Singapore 470131 (SG); LIN, Dian-Hua, Singapore 596741 (SG)
(74) Representative: Dummett Copp LLP
(86) International application number: PCT/SG2016/050173
(87) International publication number: WO 2017/176209

(56) References cited:
- WO-A1-00/23204
- CN-A- 102 136 268
- CN-A- 104 811 879
- US-A- 4 968 914
- US-A1- 2004 207 293
- HUANG Y ET AL: "High-Bending-Stiffness Connector (HBSC) and High-Authority Piezoelectric Actuator (HAPA) Made of Such", ACTUATORS, vol. 7, no. 3, 61, 12 September 2018 (2018-09-12), XP055656799, DOI: 10.3390/act7030061

## Description

### TECHNICAL FIELD

The present invention relates to displacement connectors of high bending stiffness and, in particular, to high-performance piezoelectric actuators.

### BACKGROUND

Compact, high-authority and high-fidelity piezoelectric actuators, i.e. those of relatively high displacements (≥60 µm) and blocking forces (≥50N) and with minimum hysteresis, are needed in many technological sectors including industrial, aerospace, defense, medical and scientific. Reference is made to "The Shock and Vibration Digest", vol. 33 (2001), pp.269-280, titled: "Piezoelectric actuation: state of the art", by Niezrecki, C. et al.

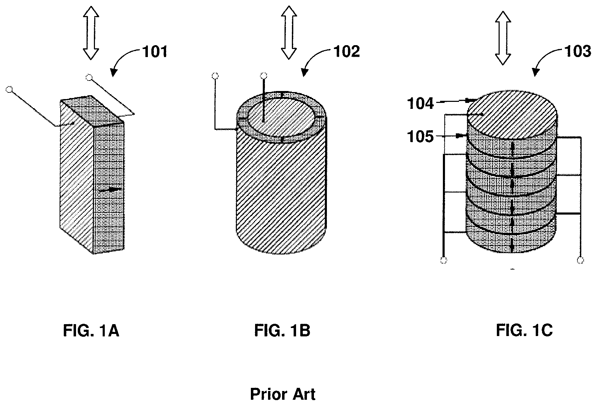

Direct push-pull piezoelectric actuators include longitudinal (d₃₃) stacked and transverse (d₃₁) tube actuators. They are of large blocking forces but low displacements, typically being about >100N and <40 µm. To attain displacement >40 µm, stacks consisting of hundreds of layers and measuring more than 100mm in height are commercially available. Schematics of direct push-pull piezoelectric actuators according to prior art are provided in **FIGS. 1A-1C. FIG. 1A** illustrates a transverse (d₃₁ and d₃₂) bar **101,** **FIG. 1B** illustrates a transverse (d₃₁) tube **102,** and **FIG. 1C** illustrates a longitudinal (d₃₃) stack **103.** As shown in **FIGS. 1A-1C****,** short arrows indicate the electrical poling direction used in the fabrication of respective active materials and large dual-head arrows indicate the activating (i.e., intended displacement) direction.

The starting material can be any individual direct push-pull piezoelectric rectangular bar, rod or tube of either longitudinal (d₃₃) or transverse (d₃₁ or d₃₂) mode **(****FIGS. 1A** and **1B****)** including their assemblages, such as d₃₃ stacks (**FIG. 1C**), bonded transverse-mode bars of solid or hollow cross-sections, including but not limited to bonded assemblages of piezoelectric single crystals of triangular, square and other polygonal-pipe cross-sections as disclosed in International Patent Application WO 2013/100860 A1, titled: "Costeffective single crystal multi-stake actuator and method of manufacture", by Xia, Y.X et al. They are hereafter collectively referred to as the "active elements".

Preferably, the active elements should be ones of high piezoelectric strain coefficients and hence displacement strokes. Examples of such constructs include stacked bars, rods or hollow cylinders of longitudinal (d₃₃) mode of piezo-ceramics and single crystals, and individual or assemblage of transverse (d₃₂ and d₃₁) bars of piezo-single crystals.

In direct push-pull application, for a given applied electric field or voltage, the displacement of an active element is proportional to its dimension in the active direction, while the blocking force is proportional to its cross-sectional (or load bearing) area. Simple actuators made of these direct push-pull elements typically have high regenerative forces but limited displacements, being typically >100N and < 40 µm.

Various displacement enhancement mechanisms have been devised to increase the displacement of these direct push-pull active elements, including lever-arm **(****FIGS. 2A-****2B),** flextensional **(****FIGS. 3A-3C****),** and meander-line and/or telescopic **(****FIGS. 4A-4B****)** approaches.

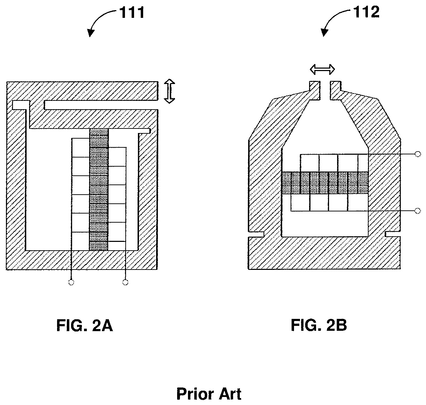

U.S. Patent No. 4,570,095, titled: "Mechanical amplification mechanism combined with piezoelectric elements" issued to Uchikawa, and U.S. Patent No. 4,783,610, titled: "Piezoelectric actuator" issued to Asano, disclose lever-arm actuators. Such lever-arm actuators utilize the lever-arm mechanism to increase the displacement of direct push-pull actuators although the force output of the device is decreased as a result. In such a design, the fulcrum typically consists of a thin flexible member while the arm is much thicker and hence much more rigid. In addition to being displacement actuators, they are popularly used as grippers in robots. Schematics of various lever-arm actuators 111 and **112** according to prior art are provided in **FIGS. 2A-2B** respectively.

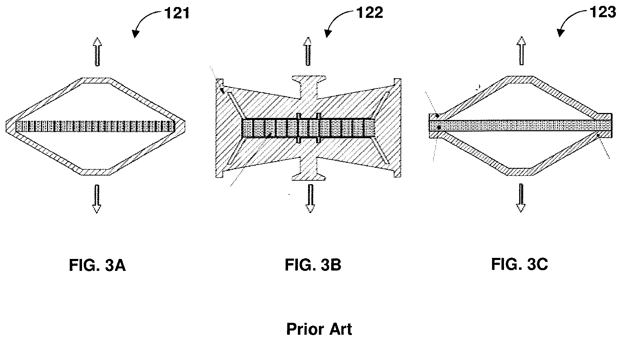

Flextensional actuators are disclosed in U.S. Patent No. 3,277,433, titled: "Flexural-extensional electromechanical transducer" issued to Toulis, and "Applied Acoustics", vol. 3 (1970), pp.117-126, titled: "The flextensional concept: A new approach to the design of underwater acoustic transducers" by Royster, L.H. Flextensional actuators comprise a group of actuators in which the motion generated by the push-pull actuator is converted to a much larger displacement in the transverse direction by means of an elastic flextensional member, the latter typically being made of metal. They include the oval (in U.S. Patent No. 5,742,561, titled: "Transversely driven piston transducer" issued to Johnson), moonie (in U.S. Patent No. 5,276,657, titled: "Metal-electroactive ceramic composite actuators", issued to Newnham), cymbal (in U.S. Patent No. 5,729,077, titled: "Metal-electroactive ceramic composite transducer", issued to Newnham) and bow (Integrated Ferroelectrics, vol. 82 (2006), pp.25-43, titled: "Piezo-bow high displacement and high blocking force actuator" by Joshi, M. et al., 2006) actuators. Moonie and cymbal actuators consist of a piezoelectric disk sandwiched by two end caps. Radial displacement of the disk flexes the end caps, producing much enhanced displacement in the axial direction. Schematics of various flextensional actuators **121, 122** and **123** for enhancing the displacement of push-pull actuators according to prior art are provided in **FIGS. 3A-3C** respectively. The lead wires connecting to the active materials are not shown for clarity of illustration.

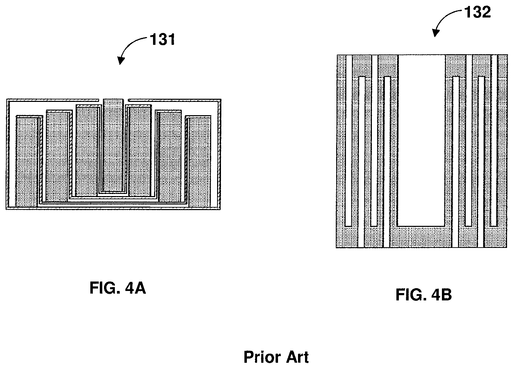

Telescopic, in U.S. Patent No. 4,510,412, titled: "Piezoelectric displacing devices" issued to Suda, and meander-line in Transactions of the IEEE Ultrasonics, Ferroelectrics and Frequency Control, vol. 38 (1991), pp.454-460, titled: "High displacement piezoelectric actuator utilizing meander-line geometry Part 1: Experimental characterization" by Robbins, W.P. et al., architectures have also been used to increase the displacement of push-pull actuators. Such actuators, however, are brittle when the entire actuator is molded as a single-piece piezo-ceramic. Schematics of telescopic and meander-line actuators **131** and **132** according to prior art are provided in **FIGS. 4A-4B** respectively. The lead wires connecting to the active materials are not shown for clarity of illustration.

US 2004/207293 A1, titled "Telescoping piezoelectric actuator", discloses an expandable piezoelectric actuator with a 3-stage telescoping mechanism for increased displacement compared to conventional piezoelectric stack actuators. The loading in said device is cantilever in nature and this has led to significant reduction of the generative force.

In addition, U.S. Patent No. 4,968,914, titled "High resolution electromechanical translation device", discloses a translation apparatus for high resolution translation in one or two dimensions for use in high resolution positioning instruments such as microscopes and optical instruments. The translation apparatus includes a channel having opposing interior bearing surfaces, and a translation drive assembly which negotiates the channel. It should be mentioned that while said translational device offers unlimited linear displacement, it has low generative or blocking force and hence is unsuitable for use as actuators for vibration control and suppression.

Further, WO 00/23204 A1, titled: "Device for accurate position control of a force-transmitting system", discloses a device for accurate position control of a force-transmitting system comprising at least one solid-state piezo actuator. The device comprises a metal block which, in the direction of the force, has at least one duct into each of which a stacked piezo element fits, the height of the block being shorter than the length of the piezo elements and the difference in height corresponding to the shortening of the piezo elements under the maximum permissible axial load acting thereon. The metal block thus serves as a means of protection to prevent the stacked piezoelectric elements from being overloaded.

However, all the displacement enhancement mechanisms of prior art suffer from high bending compliance, severely compromising the performance of the resultant actuators. Due to large bending compliance of the mechanical connectors used for displacement enhancement, both the displacement and blocking forces of devices made of the above-described displacement enhancement mechanisms are adversely affected as a result.

Stacked actuators and hence active elements of solid triangular cross-section however, remain unavailable to-date due possibly to their weak sharp corners and higher cost of fabrication. Similarly, transverse mode active elements of triangular-pipe cross-section also remain unavailable to date.

A need, therefore, exists for a connector of high bending stiffness (HBS) that overcomes the above drawbacks.

### SUMMARY OF THE INVENTION

According to a first aspect of the invention, there is provided a rigid connector for use with a plurality of piezoelectric active elements to form a multi-level axial displacement piezoelectric actuator of large overall axial displacement and blocking forces, as set forth in claim 1 of the appended set of claims.

According to a second aspect of the invention, there is provided an assemblage comprising at least one connector of the first aspect of the invention, at least one upper piezoelectric active element and at least one lower piezoelectric active element wherein said at least one upper piezoelectric active element protrudes from said first base and said at least one lower piezoelectric active element protrudes from said second base. According to a third aspect of the invention, there is provided an actuator comprising at least one assemblage of the second aspect of the invention, wherein the upper piezoelectric active elements and the lower piezoelectric active elements work in unison and contribute to the overall axial displacement of the actuator.

According to a fourth aspect of the invention, there is provided an underwater projector comprising a motor section having at least one connector of the first aspect of the invention and/or at least one assemblage of the second aspect of the invention.

The following summary is provided to facilitate an understanding of some of the innovative features unique to the disclosed embodiment and is not intended to be a full description. A full appreciation of the various aspects of the embodiments disclosed herein can be gained by taking into consideration the entire specification, claims, drawings, and abstract as a whole.

It is, therefore, one aspect of the disclosed embodiments to provide for a connector of high bending stiffness (HBS) that has minimum or no bending displacement.

It is, therefore, another aspect of the disclosed embodiments to provide for HBS-connectors having alternating recess housings which are arranged circumferentially to enable the top and bottom-directed active elements to be fitted circumferentially.

It is, therefore, yet another aspect of the disclosed embodiments to provide for HBS-connectors having the cross-section of the recess housings as close as possible to that of the active elements to reduce the load span at their bases.

It is, therefore, another aspect of the disclosed embodiments to provide for HBS-connectors having the bases of the recesses firmly connected to the main body of the connector to eliminate possible cantilever effect.

It is, therefore, another aspect of the disclosed embodiments to provide for HBS-connectors having a thick outer ring or shell to further minimize its bending displacement during use.

It is, therefore, yet another aspect of the disclosed embodiments to provide for connectors of high bending stiffness, through the use of additional top and bottom stiffening plates where appropriate.

It is, therefore, yet another aspect of the disclosed embodiments to provide for a high bending stiffness (HBS) connectors and displacement multipliers having circumferentially alternating recess housings and a sufficiently thick outer ring or shell when needed which, when fitted with the intended piezoelectric active elements to make displacement actuators, approximately double (2x), triple (3x) or quadruple (4x) the displacement of individual active elements without adversely jeopardizing their regenerative forces.

It is, therefore, yet another aspect of the disclosed embodiments to provide for a connector that may take any overall cross-section and length to suit intended applications.

It is, therefore, yet another aspect of the disclosed embodiments to provide for a connector in which the recess housings can be suitably configured to house piezoelectric elements of a wide variety of cross-sections and dimensions, including longitudinal mode stacks, transverse mode bars and/or tubes, single crystal blocks of suitable cut and dimensions and their bonded assemblages.

It is, therefore, yet another aspect of the disclosed embodiments to provide for derivative devices such as high-performance displacement actuators and compact Langevin low-frequency underwater projectors, made of HBS, HBS-2x, HBS-3x and HBS-4x connectors.

It is, therefore, yet another aspect of the disclosed embodiments to provide for active elements of solid triangular or triangular-pipe cross-section of either longitudinal (d₃₃) mode or transverse (d₃₁ or d₃₂) mode.

Other aspects and advantages of the invention will become apparent from the following detailed description, taken in conjunction with the accompanying drawings, illustrating by way of example the principles of the invention.

### BRIEF DESCRIPTIONS OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the disclosure is not limited to specific methods and instrumentalities disclosed herein. Moreover, those in the art will understand that the drawings are not to scale. Wherever possible, like elements have been indicated by identical numbers. In the drawings:
**FIG. 1A-1C** show schematics of prior art direct push-pull piezoelectric actuators of various configurations of transverse (d₃₁ and d₃₂) bar, transverse (d₃₁) tube and longitudinal (d₃₃) stack respectively;
**FIGS. 2A** and **2B** show schematics of various prior art lever-arm designs for enhancing the displacement of push-pull actuators;
**FIGS. 3A-3C** show schematics various prior art flextensional designs for enhancing the displacement of push-pull actuators;
**FIGS. 4A** and **4B** show schematics of meander-line and telescopic designs for enhancing the displacement of push-pull actuators respectively;

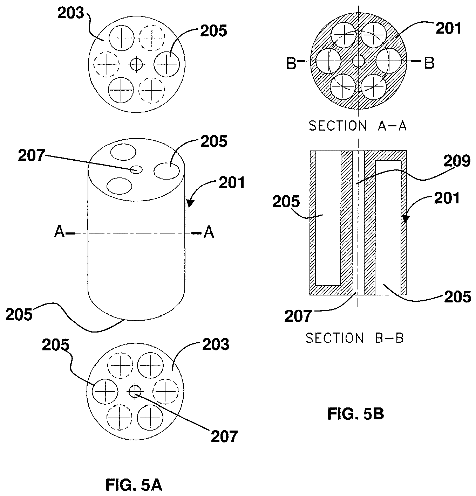

**FIGS. 5A** and **5B** show an example of cylindrical HBS-2x (element-to-element) connector of the present invention having six equally-spaced recess housings of circular cross-section, three per level or per set of either top-directing or bottom-directing recesses;

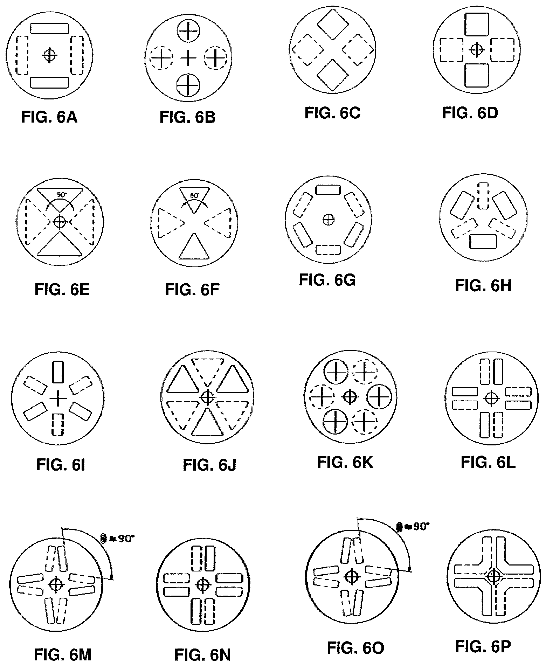

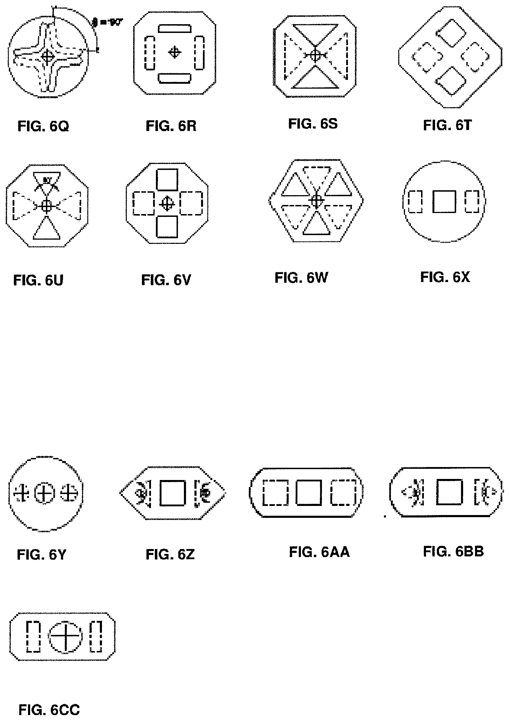

**FIGS. 6A-6CC** show examples of possible designs of HBS-2x-connector of the present invention, wherein, **FIGS. 6A-6F** show those with two active elements per level, **FIGS. 6G-6K** those with three active elements per level, **FIGS. 6L-6Q** those with more than three active elements per level for elements of different cross-sections, while **FIGS. 6R-6W** show connectors of different overall cross-sections, and
**FIGS. 6X** - **6CC** are example designs of 2x-HBS-connector in which the total number of alternating recess housings and hence the active elements are kept to the minimum;

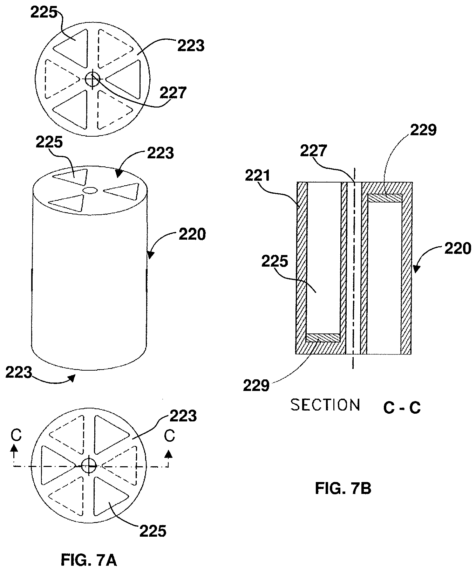

**FIGS. 7A** and **7B** show an example of the use of thin but high-stiffness load pads of appropriate dimensions which are bonded to the base of individual recess housings of a HBS-2x-connector of the present invention to further limit the deflection of the bases during use;

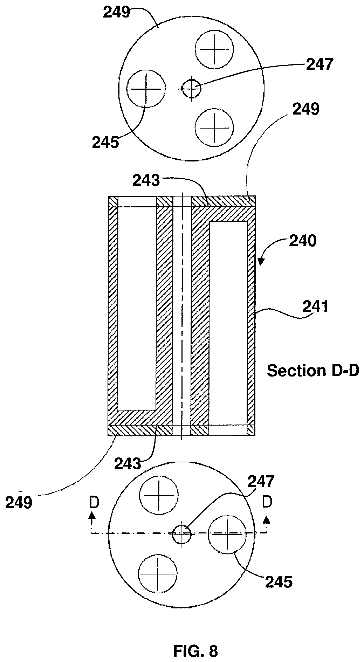

FIG. 8 shows an example of the use of specially-shaped thin but high-stiffness plates which are screwed or bonded rigidly onto the top and bottom faces of a HBS-2x-connector of the present invention to further limit the deflection of the connector;

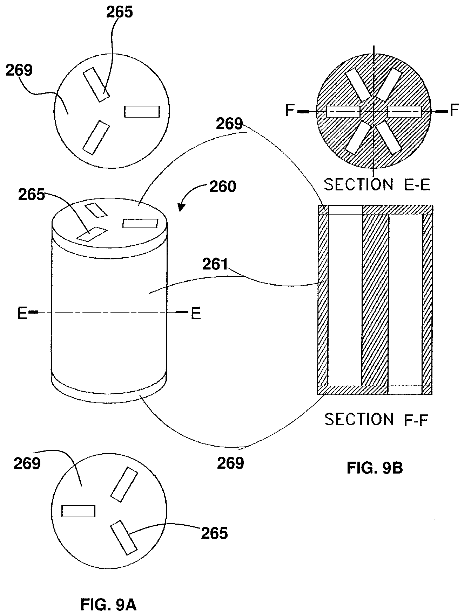

**FIGS. 9A** and **9B** show an example of a multi-part design of an HBS-2x-connector, in accordance with the present invention;

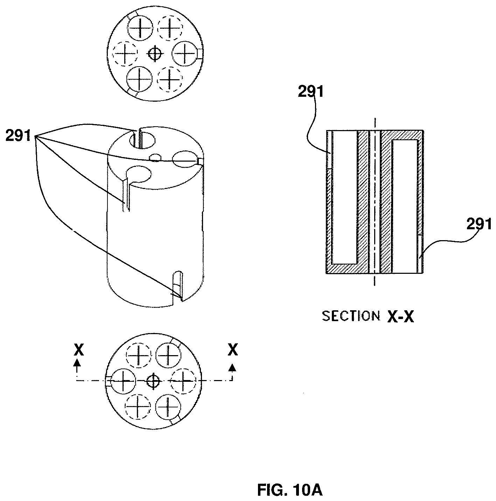

**FIGS. 10A -10C** show examples of suitable openings made in the main body of a HBS-2x-connector of the present invention for easy device fabrication purposes;

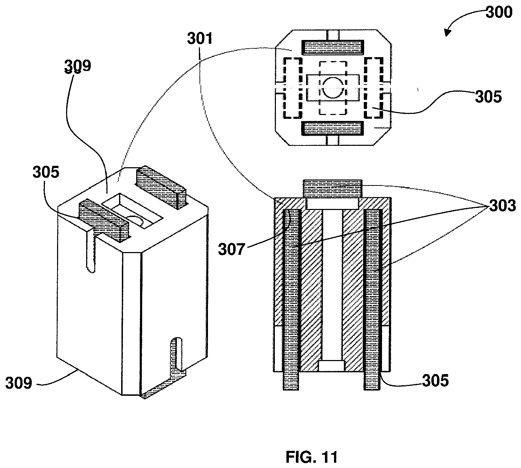

**FIG. 11** shows various views of an example of a square HBS-2x-assemblage, in accordance with the present invention;

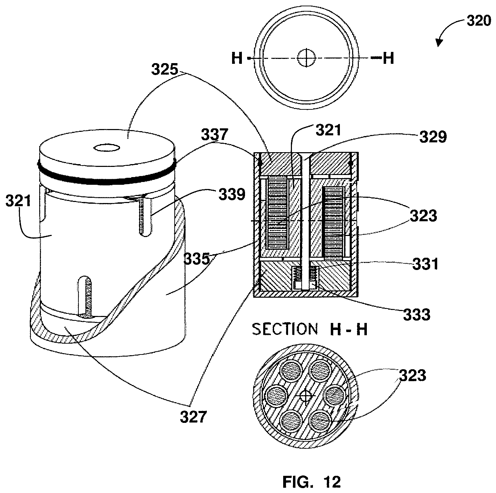

**FIG. 12** shows an example of a two-level actuator made of a cylindrical HBS-2x-assemblage, in accordance with the present invention;

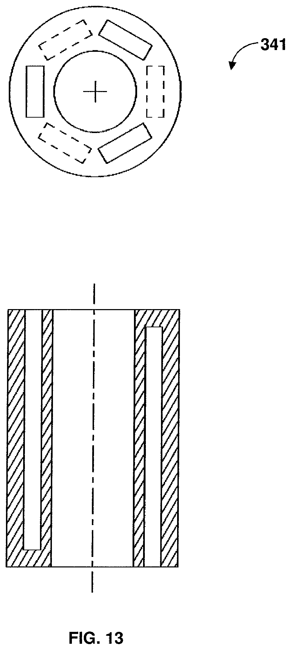

**FIG. 13** shows an example of a ring HBS-2x-connector having six active elements of rectangular cross-section, three per level;

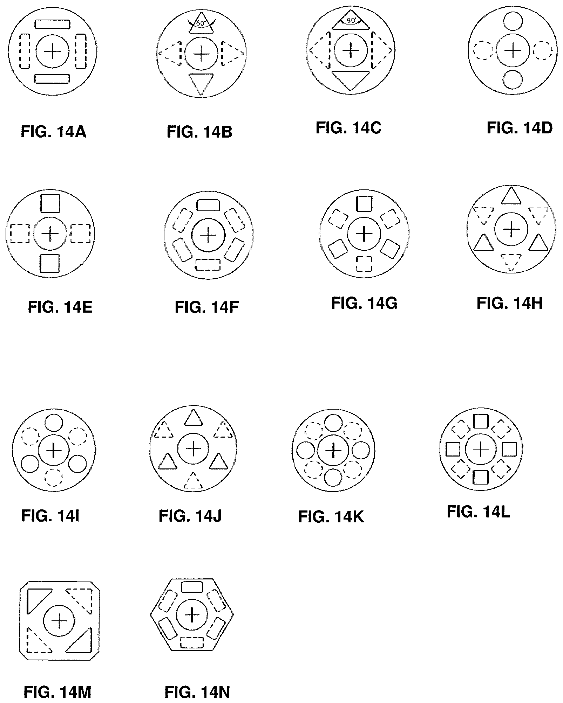

**FIGS. 14A-14N** show examples of possible designs of ring and pseudo-ring HBS-2x-connectors, in accordance with the present invention;

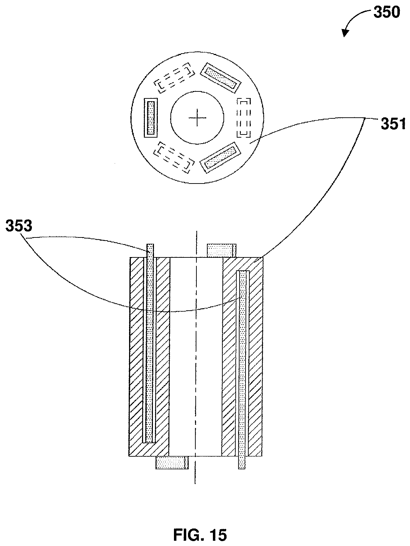

**FIG. 15** shows an example of a ring HBS-2x-assemblage, in accordance with the present invention;

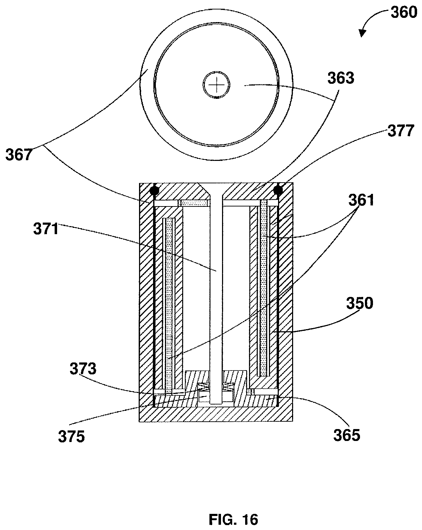

**FIG. 16** shows an example of a two-level ring actuator made of a ring HBS-2x-assemblage, in accordance with the present invention;

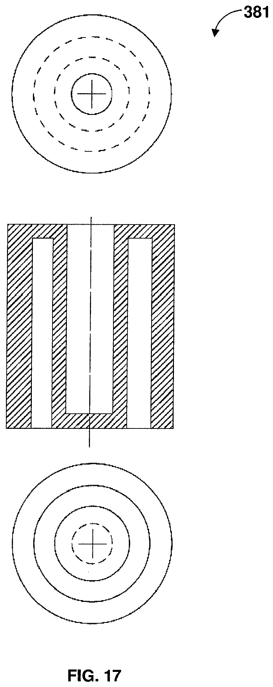

**FIG. 17** shows an example of a concentric ring HBS-2x-connector design, outside the scope of the present invention;

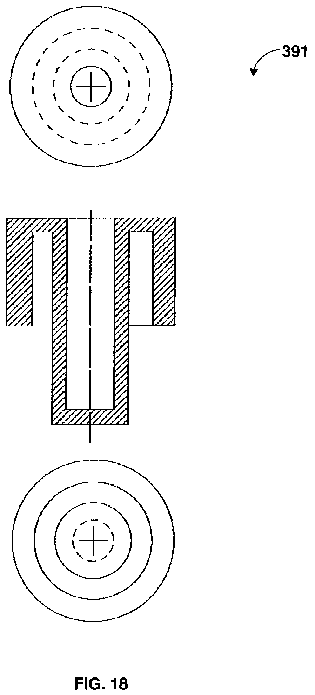

**FIG. 18** shows a modified design of the concentric ring HBS-2x-connector of FIG. 17 with shorter outer shell for ease of device fabrication;

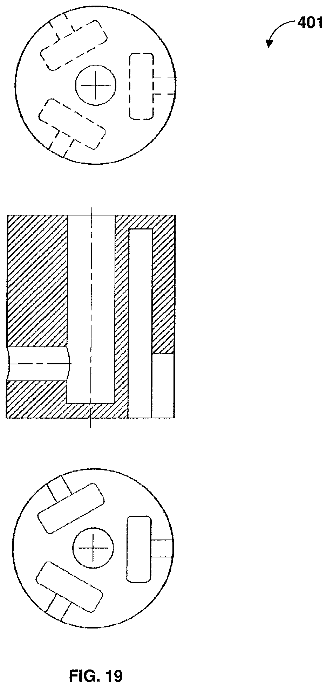

**FIG. 19** shows another design of improved bending stiffness connector outside the scope of the present invention in which the outer ring recess is replaced with segmented recesses of either rectangular or curved cross-sections for housing individual active elements of matching cross-section;

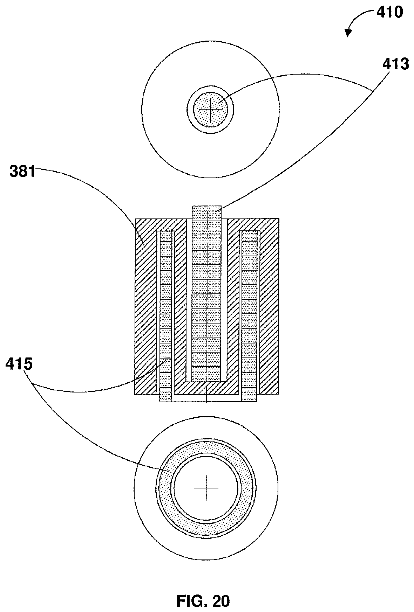

**FIG. 20** shows an example of HBS-2x-assemblage outside the scope of the present invention consisting of a HBS-2x-connector shown in **FIG. 17****;**

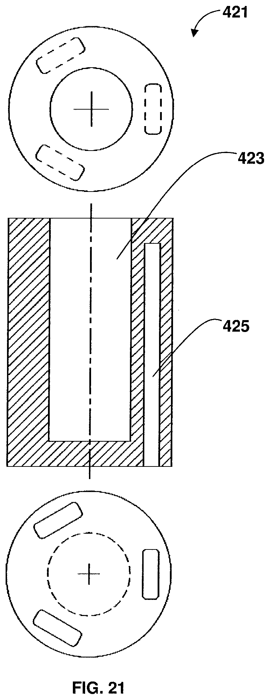

**FIG. 21** shows an example design of a cylindrical HBS-3x-connector in accordance with the present invention;

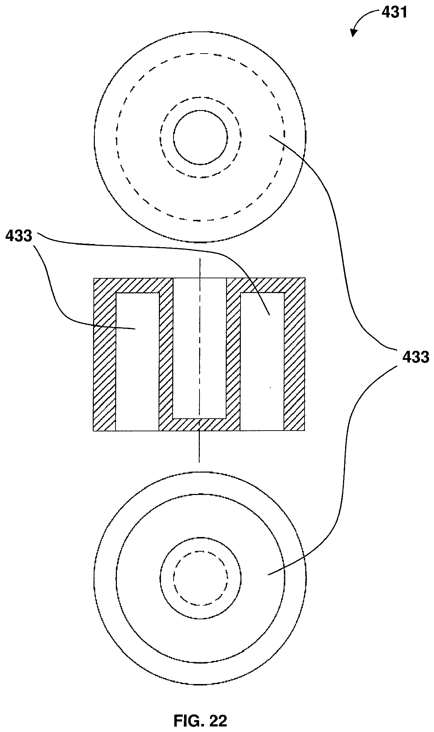

**FIG. 22** shows another example design of cylindrical HBS-3x-connector of concentric ring configuration of **FIG. 21****;**

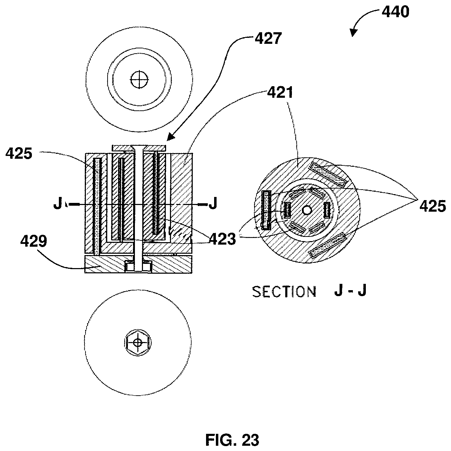

**FIG. 23** shows an example of a three-level actuator made from the HBS-3x-connector of **FIG. 21****;**

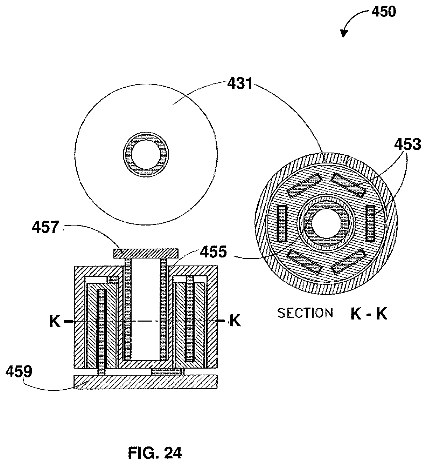

**FIG. 24** shows yet an example of a three-level actuator made from the HBS-3x-connector of **FIG. 22****;**

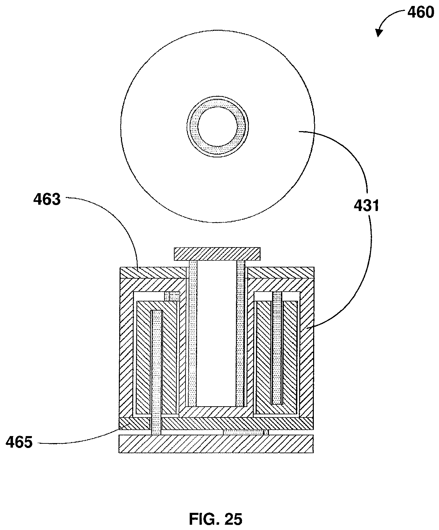

**FIG. 25** shows an example of a three-level actuator as in **FIG. 24** but with additional top and/or bottom stiffening disks or plates for high blocking force application;

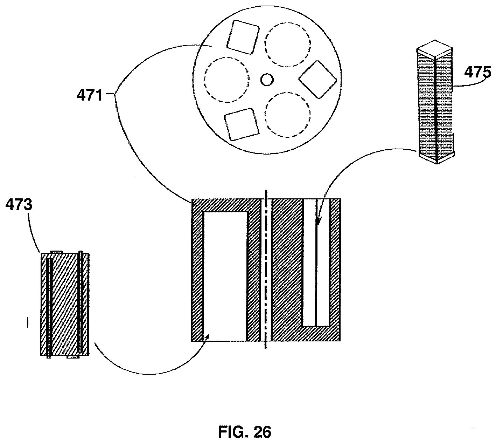

**FIG. 26** shows yet another example of a HBS-3x-connector, in accordance with the present invention;

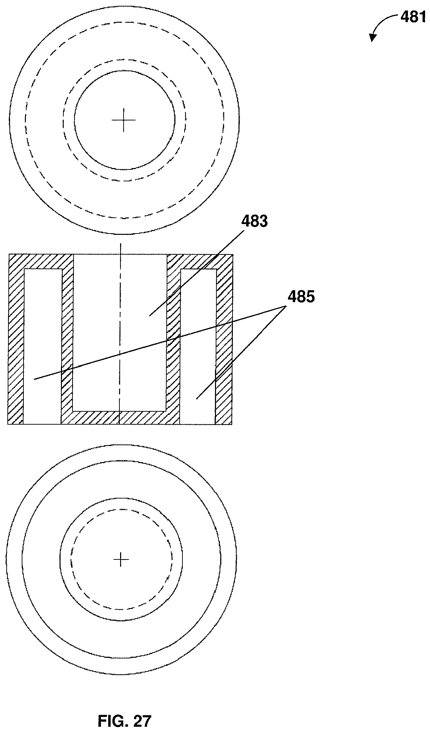

**FIG. 27** shows an example design of a HBS-4x-connector, in accordance with the present invention;

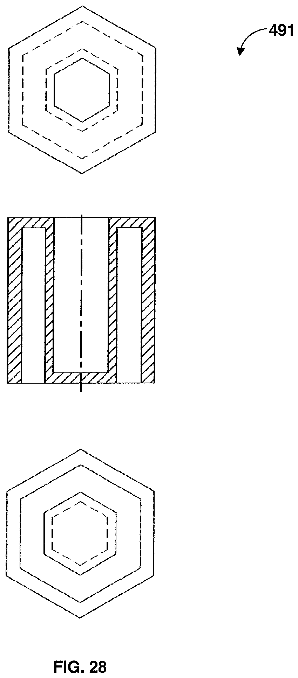

**FIG. 28** shows another example design of the HBS-4x-connector of the present invention but of polygonal overall cross-section instead;

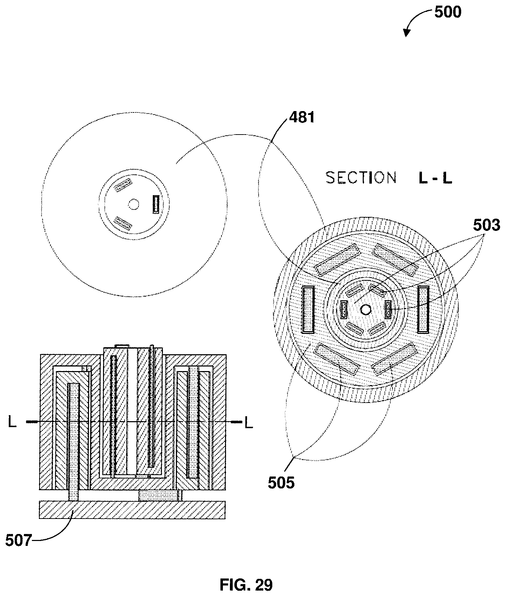

**FIG. 29** shows an example of a four-level actuator made from the HBS-4x-connector of **FIG. 27****;**

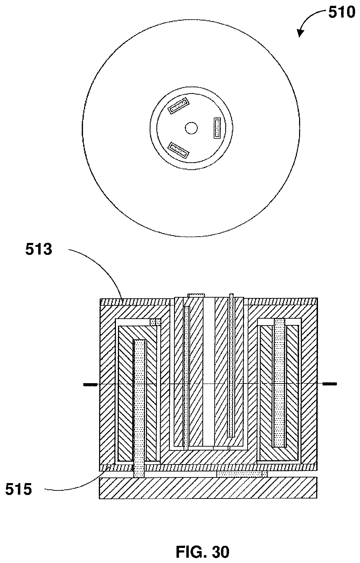

**FIG. 30** shows an example of a design of an HBS-4x-actuator suitable for high blocking force applications;

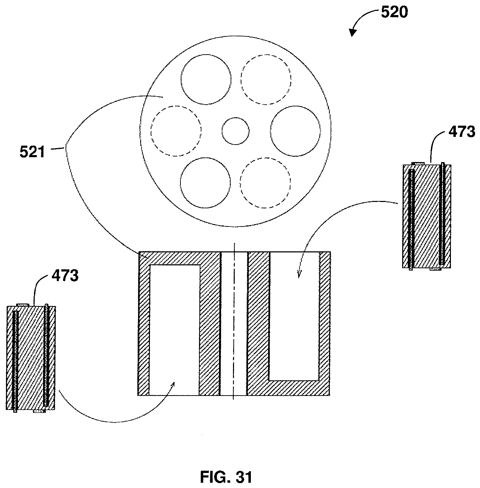

**FIG. 31** shows an example of a design of an HBS-4x-connector and assemblage of the present invention, in which all the top- and bottom-directed cylindrical HBS-2x-assemblages are positioned circumferentially; and

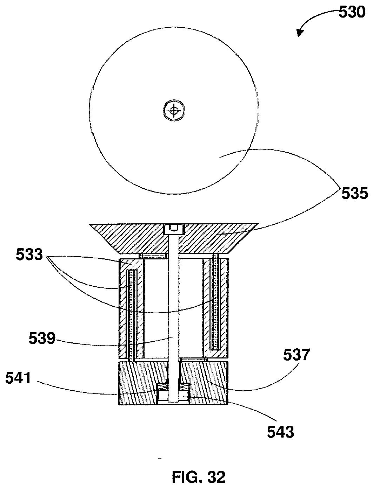

**FIG. 32** shows an example of derivative device made from an HBS-2x-connector, in accordance with the present invention.

### DETAILED DESCRIPTION OF THE INVENTION

The particular values and configurations discussed in these non-limiting examples can be varied and are cited merely to illustrate at least one embodiment and are not intended to limit the scope thereof.

Three types of high bending stiffness (HBS) connectors-cum-displacement multipliers are disclosed:(i) HBS element-to-element (2x) connectors and associated HBS-2x-assemblage, (ii) HBS-element-to-assemblage (3x) connectors, and (iii) HBS assemblage-to-assemblage (4x) connectors. These devices, when fitted with piezoelectric active elements and accompanied inactive parts, are referred to as: (i) HBS-2x-actuators, (ii) HBS-3x-actuators and (iii) HBS-4x-actuators, respectively.

### 2x-High-Bending Stiffness (HBS) Connectors, Assemblages and Actuators

The HBS-2x-assemblage, or HBS-assemblage refers to a HBS-2x-connector fitted with appropriately wired active elements, but without any pedestal, base plate, or casing included, such as found in an actuator fabrication.

Typical materials and compounds for these active elements are lead zirconate titanate [PbZrO₃-PbTiO₃] piezo-ceramics and their compositionally modified derivatives, and/or high-piezoelectricity lead-based relaxor solid solution single crystals of suitable compositions and cuts, including lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate-lead titanate [Pb(Mg_{1/3}Nb_{2/3})O₃-PbZrO₃-PbTiO₃], lead indium niobate-lead magnesium-niobate-lead titanate [Pb(In_{1/2}Nb_{1/2})O₃-Pb(Mg_{1/3}Nb_{2/3})O₃-PbTiO₃] solid solutions and their compositionally modified derivatives. In an exemplary embodiment, each piezoelectric active element comprises one of: (i) a longitudinal (d₃₃) mode active element, (ii) a transverse (d₃₁) mode active element, or (iii) a transverse (d₃₂) mode active element, each active element comprising either a single piece or multi-piece bonded assemblage of piezo-ceramics or piezo single crystals.

An exemplary embodiment of an HBS-2x-connector 201 is provided in FIG. 5A, comprising a component which has a substantially cylindrical overall shape with upper and lower bases **203.** **FIG. 5B** shows section A-A and section B-B views of the HBS-2x-connector **201.The** upper and lower bases **203** are unitary with the cylindrical portion of the HBS-2x-connector **201,** that is, may be fabricated as a single unit for maximum rigidity and resistance to bending. The upper and lower bases **203** are also referred as first and second bases **203.** The bases **203** may be in opposed parallel configuration to one another, as shown in the illustration, with the planes of the bases **203** substantially perpendicular to a longitudinal axis **209** of the HBS-2x-connector **201** shown in Section B-B. The HBS-2x-connector **201** contains specially-shaped and equally-spaced connector recesses **205** for housing a total of six longitudinal (d₃₃) or transverse (d₃₁ or d₃₂) mode push-pull piezoelectric active elements (not shown) and accordingly, providing an electromechanical transducer of novel and useful configuration.

It should be understood that more or fewer than six piezoelectric active elements or element stacks comprising: (i) a piezoelectric rectangular bar, a rod or a tube of either longitudinal (d₃₃) or transverse (d₃₁ or d₃₂) mode crystals,(ii) including their assemblages, such as d₃₃ stacks, bonded transverse-mode bars of solid or hollow cross-sections, (iii) including but not limited to bonded assemblages of piezoelectric single crystals of triangular cross-section, or square cross-section, or other polygonal-pipe cross-sections, can be used in any of the HBS-2x-assemblages described herein and claimed as the invention.

In the exemplary embodiment of **FIG. 5A****,** three connector recesses **205** extend into the HBS-2x-connector **201** from each base **203.** That is, the long dimensions of the connector recesses **205** are substantially parallel with the longitudinal axis **209** of the HBS-2x-connector **201.** This configuration accommodates both top-directing and bottom-directing active elements, and is further present in the embodiments disclosed herein and illustrated in the figures described below. The configuration shown in **FIG. 5A** is for housing, or substantially enclosing, active elements of circular cross-section, but active elements of other cross sectional shapes can also be accommodated in connector recesses of different cross-sectional shapes, as shown in the various figures described below. For example the piezoelectric active elements comprise a cross sectional shape of a solid triangle, a hollow triangle, a solid square, a hollow square, a rectangle, a solid circle, a ring, or a pseudo-ring of a polygonal form. A central connector hole **207** passes through the HBS-2x-connector **201** and is used for the insertion of an optional stress rod (not shown) in making the actuator, or electromechanical transducer. In an exemplary embodiment, the longitudinal axis of the central connector hole **207** is coincident with the longitudinal axis **209.**

**FIGS. 6A-6CC** show schematic plan views of additional exemplary configurations of HBS-2x-connectors of the present invention, in which the solid lines represent the profiles of the connector recesses for the top set of active elements, while the hidden (dashed) lines represent connector recesses for the bottom set of active elements. **FIGS. 6A-6F** are related to designs with two active elements per level. **FIGS. 6G-6K** are related to designs with three elements per level. **FIGS. 6L-6Q** are related to designs with more than three elements per level. **FIGS. 6R-6W** represent connectors of different overall cross-sections.

For cost effectiveness purposes, the HBS-2x-connectors may be configured such that the number of alternating connector recesses and hence that of the active elements employed are kept to the minimum possible, provided that the resultant displacement device is stable during use, as can be seen in the design examples of HBS-2x-connectors shown in **FIGS. 6X** - **6CC****.** Moreover, the elements and the connectors can be of any suitable cross-sections, and the number of elements per level may vary to suit a particular application. An optional central connector hole, shown in some configurations, provides for the insertion of a stress rod in making the actuator.

As can be appreciated by one skilled in the art, other similar examples of HBS-2x-connectors are also possible, where the HBS-2x-connectors include the following key features.

For the HBS-2x-connectors of the present invention, the alternative connector recesses for the top- and bottom-directed elements (i.e., the top and bottom sets of active elements) are arranged circumferentially as opposed to radially as in prior art (e.g., **FIG. 4**). And, to avoid large bending compliance exhibited by actuators of prior art, preferably, a one-piece connector design is adopted such that the cross-sections of the connector recesses are kept as close as possible to that of the active elements to minimize the load span. The bases form a unit with the cylindrical body of the connector along their circumferences to eliminate cantilever loading effects. The all-round support of the bases along their circumferences, with minimum load span and cantilever loading, are key features of the present invention which together account for the high rigidity of the connector and hence bending stiffness. As seen from **FIG. 5B****,** and the other figures below, each connector recess extending from one base is disposed either: (i) between two connector recesses extending from the other base, or (ii) adjacent to at least one connector recess extending from the other base.

In addition to the all-round support along the circumference, the bases of the connector are of sufficient thicknesses and rigidity to limit deflection of the connector to an accepted value under full load.

As a means to further reduce the deflection of the bases of the connectors, thin but high-stiffness load pads of cross-sections approximating that of a connector recess may be bonded onto the base inside a respective connector recess. An example of such reduction in deflection is shown in a modified connector **220** in **FIG. 7A** in which connector recesses **225** are meant to house active elements of triangular cross-section. As can be seen from the illustration, the connector **221** is similar to the connector **201** in **FIG. 5A** with the exception that the connector **221** includes the connector recesses **225** of triangular cross-sectional shape, rather than circular cross sectional shapes as found in the connector recesses **205.** In the example provided, in **FIG. 7A****,** three connector recesses **225** extend from each base **223.** The modified connector **220** includes a central connector hole **227** for an optional stress rod (not shown). As shown in the cross sectional view C-C of **FIG. 7B****,** a stiffening pad **229** may be bonded, or otherwise attached, to the bottom of one or more of the interior surfaces of the connector recesses **225.**

Alternatively, suitably shaped top and bottom stiffening plates **249** may be used as top and bottom connector bases. The top and bottom stiffening plates **249** can be mechanically fastened and/or bonded to the connector **241.** Moreover, the top and bottom stiffening plates **249** can be used instead of, or in addition to, the stiffening pads **229** as in **FIG. 7B****,** as in a modified connector **240** shown in **FIG. 8****.** Top and bottom stiffening plates **249** may be screwed and/or bonded rigidly onto the bases **243** of a connector **241** in the modified connector **240.** The stiffening plates **249** preferably have suitable openings **245, 247** to enable active elements or stress rod (not shown) to protrude and function as intended.

Alternatively, a multi-part design of a modified HBS-2x-connector **260** may be adopted, as shown in **FIGS. 9A-9B****,** in which connector recesses **265** in a connector **261** are configured to house active elements of rectangular cross-section (not shown). In such a design, the rectangular through-holes, also referred as the connector recesses **265** in the connector **261** are meant for housing the active elements. Top and bottom high stiffness plates **269** of only half the number of similarly shaped holes are rigidly screwed and/or bonded onto the connector **261** to form the modified connector **260** as shown. Section E-E shown all six connector recesses **265,** and Section F-F show the placement of the high stiffness plates **269** onto the connector **261.**

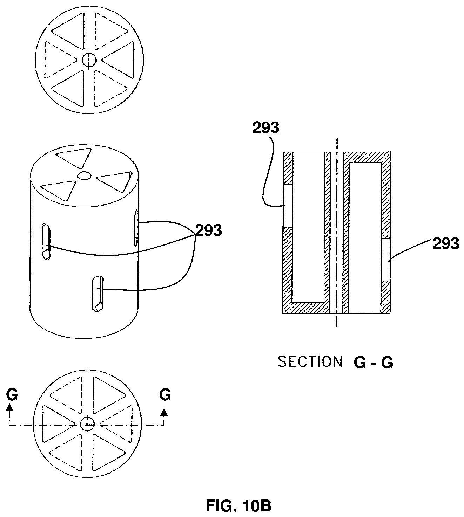

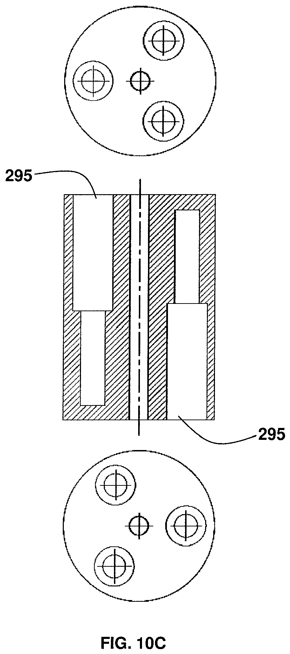

To aid in the handling of the disclosed actuators during fabrication, side openings **291,** side openings **293** and base openings **295** of various forms and dimensions may be incorporated in non-critical part of the connector. Examples of such are shown in **FIGS. 10A****,** **10B** and **10C****.** Care should be exercised to ensure that such openings produce no adverse effect to the stiffness of the connector, namely, they should not lead to significant increase in the deflection of the connector during use.

**FIG. 11** shows top, sectional, and isometric views of an example of an HBS-2x-assemblage **300** comprising a HBS-2x-connector **301** of square overall cross-section, in accordance with the present invention. To form the HBS-2x-assemblage **300,** four appropriately wired active elements **303** of suitable length, that is, slightly longer than the depth of the connector recesses **305** are bonded with an suitable agent, such as epoxy, for example, onto bases **307** of respective connector recesses **305** of the HBS-2x-connector **301,** with the opposite end faces of the upper set of active elements **303** protruding from the top base **309** and the lower set of active elements **303** protruding from the bottom base **309** of the HBS-2x-connector **301** as shown. Suitable slot openings and/or wire feed-through holes may be incorporated in the design for ease of device fabrication as shown but they should not adversely affect the bending stiffness of the connector. Preferably, the total cross-sectional areas of the active elements per level are about the same so that the blocking forces produced by respective levels are approximately the same although this is not a must.

Finite element analysis on the connector configurations disclosed herein has shown that even with an aluminum connector, the bending displacement of the base of the connector produced by an axial load via the active elements is greatly reduced over the conventional designs (described above), being at most few percentage of the overall displacement. It should be noted that the bending displacement of the connector acts against the desired displacement of the resultant actuator under load and hence is undesirable. Even smaller bending displacement is expected should the connector be made of materials of higher elastic modulus including but not limited to a light metal, an engineering ceramic, an ironalloy, a nickel-alloy, a copper-based alloy, a fibre-reinforced polymer or tungsten carbidecobalt (WC-Co) cermets.

**FIG. 12** shows top, bottom, sectional, and perspective views of an example of a two-level (2x) actuator **320** made from an HBS-2x-assemblage **321** of the present invention, in which active elements **323** are made of piezoelectric ceramic stacks of a circular cross-section. To form the two-level actuator **320,** the exposed end faces of the top and bottom sets of active elements **323** of the HBS-2x-assemblage **321** are bonded with a suitable agent onto a rigid pedestal **325** and a base plate **327** of the actuator **320** respectively, as shown. A stress rod **329** with coil springs **331** and lock nuts **333** are incorporated to place the active elements **323** and the various epoxy joints in compression, which is optional. The HBS-2x-assemblage **321** is inserted into a casing **335** as shown. One or more O-rings **337** or other highly compliant materials may be used in between the pedestal **325** and the casing **335** to enable the pedestal **325** to move freely during activation. Optional slot openings **339** may be provided for ease of wire connection during device fabrication. Other designs of the pedestal **325,** the base plate **327,** pre-stress mechanism and the casing **335** are possible to suit various applications. The lead wires connecting the active elements **323** are not shown in this figure for clarity of illustration.

In contrast, **FIG. 13** and **FIG. 14A** to **FIG. 14N** show a ring HBS-2x-connector **341** of the present invention, but having ring cross-section and, alternatively, may have a polygonal pseudo-ring cross-section. Compared with the designs shown in **FIGS.** 6 to **12****,** the ring HBS-2x-connector **341** has a much larger inner bore to suit a desired application. As a result, actuators made of such HBS-2x-connectors and assemblages have larger footprints.

**FIG. 15** shows another example of an HBS-2x-assemblage **350** of the present invention.

The HBS-2x-assemblage **350** comprises a ring-shaped HBS-2x-connector **351** and two sets of three rectangular active elements **353** each. The top set of three active elements **353** protrudes from the top face of the connector **351,** while the bottom set protrudes from the bottom face. When a suitable voltage is applied to the active elements 353, the top set of active elements **353** will extend or contract in the top-pointing direction, while the bottom set of active elements **353** will extend or contract in the bottom-pointing direction, thus enabling the HBS-2x-assemblage **350** to function as a displacement actuator in both directions.

**FIG. 16** shows top and sectional views of an example of a two-level (2x) actuator **360** that includes the HBS-2x-assemblage **350,** shown in **FIG. 15****.** The active elements **361** in this configuration are transverse-mode piezoelectric single crystals or piezo-ceramic bars of rectangular shape. To form the two level actuator **360,** the end faces of the top set of active elements **361** of the HBS-2x-assemblage **350** are bonded with a suitable agent onto the base of a top rigid pedestal **363,** while the bottom set of active elements **361** are bonded to the top face of a base plate **365,** as shown. A stress rod **371** with disc springs **373** and lock nuts **375** are optional in the design of the two-level (2x) actuator **360.** The lead wires connecting the active elements are not shown in this figure for clarity of illustration. The assembly in **FIG. 16** may be used as the finished actuator or may be inserted into a protective casing **367,** as shown in the figure. In this example, an O-ring **377** is used to ensure free movement of the pedestal **363** during actuation.

Yet another example of an HBS-2x-connector 381, outside the scope of the present invention, is that of concentric ring designs but with a thick and rigid outer shell as shown via top, sectional, and bottom views in **FIG. 17****.** The thick outer shell is a key design feature of the present invention. Its thickness, together with the thickness of the bases of the connector recesses, should be such that the bending displacement of the base of the connector recesses in the axial direction of the HBS-2x connector **381** is not more than 20% of the overall displacement of individual active elements.

**FIG. 18** shows top, sectional, and bottom views of a modified design of a concentric ring HBS-2x-connector **391** with a shorter outer shell for ease of device fabrication. It is important in such a design that, the shorter outer shell is thick and rigid to limit the bending displacement of HBS-2x-connector **391** to not more than 20% of the overall displacement of individual active elements. Concentric ring designs, as illustrated in **FIGS. 17** and **18****,** are simple and cost effective to produce but they may not be as rigid as the designs shown in **FIGS. 2** to **16****.** It should be noted that the thickness of the outer shell in the ring HBS-2x-connector **381** shown in **FIG. 17** and the thickness of the outer shell in the ring HBS-2x-connector **391** shown in **FIG. 18****,** each ranges from 0.2 to 0.5 times the width of the respective connector recesses of ring shape.

A design similar to the HBS-2x-connector **391** of **FIG. 18****,** but of improved bending stiffness, is shown in top, sectional, and bottom views of **FIG. 19****.** In this design of an HBS-2x-connector **401,** there is no outer ring-like recess, but has a suitable number of segmented recesses of a circular cross-sectional shape, a triangular cross-sectional shape, a square cross-sectional shape, a rectangular cross-sectional shape, a ring shape, a polygonal cross-sectional shape, a V-channel cross-sectional shape, a T-channel cross-sectional shape, or an L-channel cross-sectional shape for housing individual active elements of similar cross-sections. The slot openings and through holes on the outer shell are for ease of device fabrication and handling, of which the dimensions and locations should be carefully selected such that they would not adversely affect the bending stiffness of the connector.

Alternatively, the segmented recesses in the outer shell of the HBS-2x-connector **401** in **FIG. 19** may be of curved or arch-shaped cross-section (not shown) to house active elements which are produced by slicing a d₃₁-mode piezo-ceramic tube length-wise into several equal pieces. Active elements made of such, however, may have reduced overall displacement due to the lower d₃₁ piezoelectric strain coefficient of present-day piezo-ceramics.

**FIG. 20** shows an example of an HBS-2x-assemblage **410** that includes the HBS-2x-connector **381** shown in **FIG. 17****,** a d₃₃ stack of either square or circular cross-section of active elements **413** in the middle connector recess of the HBS-2x-connector **381,** and a d₃₃-ring stack **415** in an annular connector recess of the HBS-2x-connector **381.** The lead wires connecting the active elements **413** and stack **415** are not shown in this figure for clarity of illustration. The HBS-2x-assemblage **410** may be used as the finished actuator. Alternatively, a protective casing (not shown) may be used in the design.

Since HBS-2x-connectors of the present invention are rigid with high bending stiffness, the displacement produced by the two-level (2x) actuator made from HBS-2x-connectors, as exemplified by **FIGS. 12****,** **16** and **20****,** will be approximately the sum of displacement exhibited by individual levels. In other words, if all active elements are of the same cut and dimensions, then the displacement produced by the two level (2x) actuator of the present invention will be approximately twice that of individual active elements, while the blocking force of the two level actuator is about n-times larger, where n is the number of active elements per level.

It should be noted that the blocking force of the resultant actuator could be increased either by: (i) using active elements of larger cross-sectional (i.e., load bearing) area, or (ii) using a larger number of active elements per level, without significantly increasing the foot-print of the actuator.

Alternatively, the blocking force of the resultant actuator may be doubled or tripled by connecting two or three units of HBS-2x-assemblages in parallel in forming the resultant actuator.

### Solid and hollow triangular cross-sectioned active elements

It can be seen from **FIGS. 5** to **20** that for a given connector cross-sectional area, HBS-assemblages with closely spaced active elements of triangular cross-sections, as in **FIGS. 6E, 6J****,** **6S** and **6W****,** offer a larger total load-bearing area and hence blocking force, bending and twisting strengths of the resultant device. Thus, active elements of solid triangular or triangular-pipe cross-section of either longitudinal (d₃₃) mode or transverse (d₃₁ or d₃₂) mode are also possible with the HBS-connector.

It is imperative that active elements of solid or hollow triangular cross-section (i) having chamfered or rounded corners, or (ii) having their acute corners protected or strengthened with adequate means, be used in making the HBS-assemblages and actuators of the present invention.

### 3x-HBS Connectors, Assemblages and Actuators

**FIG. 21** shows top, sectional, and bottom views of an exemplary HBS-3x-connector **421** of the present invention. The HBS-3x-connector **421** includes a bore **423** of sufficiently large diameter so as to accommodate a cylindrical 2x-HBS-assemblage, that includes a HBS-2x-connector according to the present invention (not shown) with top and bottom sets of active elements (not shown).

The HBS-3x-connector **421** includes connector recesses **425** suitable for housing an additional set of active elements (not shown) of the desired cross-section, which are rectangular in the example shown. The thick recess-containing outer shell provides the needed stiffening effect and is a key feature of the exemplary embodiment shown.

**FIG. 22** shows top, sectional, and bottom views of yet another example of an HBS-3x-connector **431** of the present invention. The HBS-3x-connector **431** is of similar design to the HBS-2x-connector **381** of **FIG. 17** except that an outer ring recess **433** is of sufficient width to house a ring HBS-2x-assemblage instead. The thick outer shell of the HBS-3x-connector **431** provides the needed stiffening effect and is a key feature of the present invention. Instead of circular overall cross-section, the HBS-3x-connectors **421** and **431** of the present invention can be of any overall cross-section including a square, a circular, a rectangular, a ring, and other polygonal shapes to suit various applications.

**FIG. 23** shows top, sectional, and bottom views of an example of a three level (3x) actuator **440** with a stress rod using the HBS-3x-connector **421** of **FIG. 21****.** To make the three-level actuator **440,** the cylindrical HBS-2x-assemblage **350,** shown in **FIG. 15****,** is carefully positioned inside the central recess of the HBS-3x-connector **421,** and the end faces of the bottom set of active elements **423** are bonded onto the base of the central connector recess in the HBS-3x-connector **421.** Then, an additional set of active elements **425** are bonded onto the bases of an outer, annular connector recess in the thick outer shell of the HBS-3x-connector **421.**

The top-most and bottom-most free end faces of the active elements **423** of the resultant 3x-assemblage **440** are then bonded onto a rigid pedestal **427** and the base plate **429** of the three level (3x) actuator **440,** respectively. The stress rod may then be inserted, and all the active elements **423, 425** and the adhesive joints are loaded with predetermined compression via disc springs and lock nuts. The three level (3x) actuator **440** may also be housed inside a suitable casing (not shown) for improved protection. Also not shown for clarity of illustration are the lead wires connecting to the active elements **423, 425.** Other designs of the pedestal, base plate, pre-stress mechanism and casing of the three level (3x) actuator **440** are possible to suit various applications.

**FIG. 24** shows top and sectional views of yet another example of a three-level (3x) actuator **450** made using the HBS-3x-connector **431** shown in **FIG. 22****.** To construct the three-level actuator **450,** the ring HBS-2x-assemblage may be appropriately positioned inside the outer ring recess of the HBS-3x-connector **431,** and the end faces of the bottom set of active elements **453** are bonded onto the bases of ring the connector recesses of the HBS-3x-connector **431.** Then a d₃₃ stack or a d₃₁ tube active element **455** of desired deformation characteristics, or a number of active elements of a selected configuration, is/are bonded onto the base of the central recess. The top-most and bottom-most free end faces of the active elements **455** and of the resultant 3x-HBS assemblage **350** of **FIG. 15** are then bonded onto a rigid pedestal **457** and a base plate **459** of the actuator, respectively. As in the previous example, the above assembly may be used as an actuator or it may be placed inside a suitable casing, (not shown). Also not shown, for clarity of illustration are the lead wires, lead wire through-holes, and openings for ease of fabrication. Other designs of the pedestal, base plate, pre-stress mechanism and casing of the actuator are possible to suit various applications.

The three level actuator **440, 450** designs shown in **FIG. 23** and **FIG. 24** are sufficient when the desired blocking forces are low to moderate.

When larger blocking forces are required, the bending stiffness of the HBS-3x-connectors may be further enhanced by incorporating additional stiffening disks or plates **463** and **465** onto the top and/or bottom faces of the connector **431** to make the three-level actuator **460,** as shown in **FIG. 25****.** The top and bottom stiffening disks **463, 465** or plates should have appropriate windows for the top-most and bottom-most sets of protruding active elements to enable them to function as intended.

**FIG. 26** shows yet another example of an HBS-3x-connector **471** of the present invention. In this example, all the active elements are circumferentially deposited. The large recess housings are for cylindrical 2x-HBS-assemblages **473** while the smaller ones are for the third set of active elements **475** which are of square cross-section in the figure shown. Active materials of other cross-sections can also be used to suit a particular application.

### 4x-HBS Connectors, Assemblages and Actuators

**FIG. 27** shows an example design of a HBS-4x-connector **481** for making four-level (4x) actuators of low-to-moderate blocking forces. In this design, a central recess **483** is used to house a 2x-cylindrical-HBS-assemblage according to the present invention and an outer ring recess **485** is used to house a 2x-ring-HBS-assemblage. The thick outer shell and connector recess base provide the needed stiffening effect and are key features of the present invention.

Instead of having circular overall cross-sections, the 2x-, 3x- and 4-x-HBS-connectors of the present invention can be of any suitable overall cross-section to suit various applications. As an illustration, **FIG. 28** shows a polygonal design of the HBS-4x-connector **491** which is suitable for making four level (4x) actuators of polygonal cross-section. Again, the thick outer shell and connector recess base provide the needed stiffening effect and are key features of the present invention.

**FIG. 29** shows an example of a four-level (4x) actuator **500** made from a HBS-4-connector **481** of **FIG. 27****.** To make the four-level (4x) actuator **500** using the HBS-4-connector **481,** a cylindrical HBS-2x-assemblage **503** is placed inside and bonded onto the base of the central connector recess of the HBS-4-connector **481,** while a ring HBS-2x-assemblage **505** is placed inside and bonded onto the base of the outer ring recess. The rigid pedestal (not shown) and the base plate **507** are then bonded onto the exposed top-most active element end faces of the assemblage **503** and the exposed bottom-most active element end faces of the assemblage **505,** respectively. The assembly may be used as an actuator or placed inside a suitable casing (not shown in this figure; also not shown are the lead wires and wire feed-through holes and openings for clarity of illustration) for improved protection. Other designs of the pedestal, the base plate, optional pre-stress mechanism and the casing of similar 4x-actuators are possible to suit various applications.

**FIG. 30** shows an example design of HBS-4x-actuator or four-level actuator **510** for high blocking force applications. In this example, additional top and bottom stiffening plates **513** and **515** are firmly attached to the top and bottom faces of the HBS-4x-connector **481** of **FIG. 29****.** The top and/or bottom stiffening plates or disks have appropriate openings to enable the top-most and bottom-most sets of active elements to protrude and to function as intended.

**FIG. 31** shows another example design of an HBS-4x-connector **521** and a four level actuator **520** made from the HBS-4x-connector **521,** in which alternating top- and bottom-directed cylindrical HBS-2x-assemblages **473** according to the present invention are positioned circumferentially. Such a design has a larger foot-print as opposed to those described previously but may find application when actuators of higher bending and/or twisting strength are required.

Preferably, the HBS-2x-, HBS-3x- and HBS-4x-connectors of the present invention are made of ductile and high modulus materials including but not limited to light metals, engineering ceramics and fibre-reinforced polymers.

Light metals of high elastic modulus which can be processed after machining or forming to give it an insulation surface layer will be advantageous. Anodized aluminum and suitable aluminum alloys are such materials which are highly suitable for making the HBS connectors of the present invention.

Alternatively the connectors may be made of a high-modulus and high-strength engineering materials including suitable iron-, nickel- and copper-based alloys and WC-Co cermets. In using these materials, the connector should be electrically insulated from the electrical contacts of the active elements.

### Derivative Devices

**FIG. 32** shows an example derivative device **530** made from a HBS-connector of the present invention. It shows a Langevin (or Tonpilz) underwater projector in which a HBS-2x-assemblage **533** similar to that shown in **FIG. 15** is used as its motor section together with a head mass **535,** tail mass **537,** stress rod **539,** disc springs **541** and lock nuts **543.** For a given design frequency, the use of an HBS-connector and assemblage shortens the overall height of the projector, thus making possible compact low-frequency (<15 kHz) Langevin underwater projectors. In this example, the HBS-connector acts as an intermediate mass which, when appropriately designed, also helps to increase the bandwidth of such devices.

For lower operating frequencies, Langevin underwater projectors using 3x- or 4x-HBS-assemblage as their motor section would be more appropriate. The use of HBS-connectors and assemblages thus make possible a wide range of compact low-frequency underwater projectors suitable for underwater ranging, communicators and imaging application.

It will be obvious to a skilled person that the configurations, dimensions, materials of choice of the present invention may be adapted, modified, refined or replaced with slightly different but equivalent designs without departing from the principal features of the working principle of our invention, and additional features may be added to enhance the bending stiffness of the connectors-cum-displacement-multipliers. For instance, the present concept can be extended readily to make HBS-5x and HBS-6x connector and associated five level and six level actuators via appropriate but simple design modifications. Furthermore, additional protection features, as use of corrosion resistant materials and the incorporation of anti-twisting features may be incorporated in the design of the final devices.

Moreover, any of the above disclosed active elements can be fabricated from individual and/or bonded assemblages of piezoelectric single crystal, as is known in the relevant art. For example, a component piezoelectric crystal can be a rectangular crystal bar, a crystal rod, or a crystal tube of either longitudinal (d₃₃) or transverse "(d₃₁ or d₃₂) mode. The bonded active elements can be a longitudinal or transverse-mode active element of solid or hollow cross-section, including triangular or triangular-pipe cross section, square or square-pipe cross section, or of any other polygonal-pipe cross-section.

## Claims

1. A rigid connector for use with a plurality of piezoelectric active elements to form a multi-level axial displacement piezoelectric actuator of large overall axial displacement and blocking forces, said connector comprising:
a substantially cylindrical component having a first base, and a second base in an opposed, substantially parallel relationship to said first base;
a set of multiple connector recesses equally spaced and arranged circumferentially extending substantially through the connector from said first base, perpendicular to said first base; and
a set of multiple connector recesses equally spaced and arranged circumferentially extending substantially through the connector from said second base, perpendicular to said second base, which intersperse with the set of recesses extending from the first base at approximately equal angular separation along the circumference of the connector;
wherein each connector recess can house a piezoelectric active element;
wherein the cross-section of each connector recess is substantially equal to that of the piezoelectric active element that it can house;
wherein the base of each connector recess is firmly connected to the connector body to avoid cantilever loading during use;
wherein the depth of each connector recess is preferably slightly shorter than the length of the piezoelectric active element that it can house; and
wherein the piezoelectric active elements when housed in both sets of connector recesses can operate in unison to produce an overall axial displacement approximately twice (2x) that of respective piezoelectric active elements and of blocking force comparable to or larger than that of respective piezoelectric active elements.

2. The connector as claimed in claim 1, wherein the cross-section of said connector comprises one of a circular shape, a square shape, a rectangular shape, a polygonal shape, a ring shape, or a polygonal ring shape; wherein the cross-sectional shape of said connector recess is approximately the same as the cross-sectional shape of a housed piezoelectric active element and is at least one of a circular shape, a square shape, a rectangular shape, a triangular shape, a V-channel shape, a T-channel shape, or an L-channel shape.

3. The connector as claimed in any one of the preceding claims, wherein said bases are unitary with said connector.

4. The connector as claimed in any one of claims 1 or 2, wherein said bases are mechanically fastened and/or bonded to said cylindrical component.

5. The connector as claimed in any one of the preceding claims, wherein at least one of said connector recesses for housing said piezoelectric active elements comprises a ring shape, preferably said connector recesses of said ring shape comprises an outer shell having a thickness in the range of 0.2 to 0.5 times the width of said connector recesses of said ring shape.

6. The connector as claimed in any one of the preceding claims, wherein said connector comprises at least one opening to aid handling during manufacture of actuators from said connector.

7. The connector as claimed in any one of the preceding claims, further comprising at least one load pad bonded to a base inside at least one of said connector recess, or further comprising at least one stiffening plate bonded onto one or both end faces of said connector.

8. The connector as claimed in any one of the preceding claims, wherein said connector further comprises a central connector hole passing through said connector.

9. The connector as claimed in any one of the preceding claims, wherein said connector is made of one of a high elastic modulus material, including, for example, a light metal, an engineering ceramic, or
a fibre-reinforced polymer.

10. An assemblage comprising at least one connector of claims 1 to 9, at least one upper piezoelectric active element and at least one lower piezoelectric active element, wherein said at least one upper piezoelectric active element protrudes from said first base and said at least one lower piezoelectric active element protrudes from said second base.

11. The assemblage of claim 10, wherein each of said upper and lower piezoelectric active elements comprises an individual piece or a bonded structure of piezoceramic or piezoelectric single crystal, of either longitudinal (d₃₃) or transverse (d₃₁ or d₃₂) activation mode and having an overall cross sectional shape of a solid triangle, a hollow triangle, a solid square, a hollow square, a solid rectangle, a hollow rectangle, a solid cylinder, a hollow cylinder, a ring, a pseudo-ring of a polygonal form, a V-channel shape, a T-channel shape, or a L-channel shape.

12. The assemblage of claim 10, where said piezoelectric active elements comprise at least one of a lead zirconate titanate piezoceramic or a compositionally-modified derivative of lead zirconate titanate piezoceramic, or a single crystal selected from the group consisting of lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate-lead titanate [Pb(Mg_{1/3}Nb_{2/3})O₃-PbZrO₃-PbTiO₃], and lead indium niobate-lead magnesium niobate-lead titanate [Pb(In_{1/2}Nb_{1/2})O₃-Pb(Mg_{1/3}Nb_{2/3})O₃-PbTiO₃] including their compositionally modified derivatives.

13. An actuator comprising at least one assemblage of claim 10, wherein the upper piezoelectric active elements and the lower piezoelectric active elements work in unison and contribute to the overall axial displacement of the actuator.

14. The actuator of claim 13, further comprising at least one pedestal, a base plate, a pre-stress mechanism, a casing and, optionally further comprising an anti-twist mechanism.

15. An underwater projector comprising a motor section having at least one connector of claims 1 to 9 and/or at least one assemblage of claims 10 to 12.

16. The underwater projector of claim 15, further comprising at least one of a head mass, a tail mass, a pre-stress mechanism, and a casing.

## Patentansprüche

1. Ein starrer Konnektor zur Verwendung mit einer Vielzahl von piezoelektrischen aktiven Elementen, um einen piezoelektrischen Aktuator mit mehrstufiger Axialverschiebung und großen axialen Verschiebungs- und Blockierkräften zu bilden, wobei der Konnektor Folgendes umfasst:
eine im Wesentlichen zylindrische Komponente mit einer ersten Basis und einer zweiten Basis in einer gegenüberliegenden, im Wesentlichen parallelen Beziehung zu der ersten Basis;
einen Satz von mehreren Konnektoraussparungen, die gleichmäßig beabstandet und in Umfangsrichtung angeordnet sind und sich im Wesentlichen durch den Konnektor von der ersten Basis senkrecht zu der ersten Basis erstrecken;
und einen Satz von mehreren Konnektoraussparungen, die gleichmäßig beabstandet und in Umfangsrichtung angeordnet sind und sich im wesentlichen durch den Konnektor von der zweiten Basis aus senkrecht zu der zweiten Basis erstrecken, die sich mit dem Satz von Aussparungen, die sich von der ersten Basis aus erstrecken, in ungefähr gleichem Winkelabstand entlang des Umfangs des Konnektors abwechseln;
wobei jede Konnektoraussparung ein piezoelektrisches aktives Element aufnehmen kann;
wobei der Querschnitt jeder Konnektoraussparung im Wesentlichen gleich dem des piezoelektrischen aktiven Elements ist, das sie aufnehmen kann; wobei die Basis jeder Konnektoraussparung fest mit dem Konnektorkörper verbunden ist, um eine freitragende Belastung während des Gebrauchs zu vermeiden;
wobei die Tiefe jeder Konnektoraussparung vorzugsweise etwas kürzer ist als die Länge des piezoelektrischen aktiven Elements, das sie aufnehmen kann; und
wobei die piezoelektrischen aktiven Elemente, wenn sie in beiden Sätzen von Konnektoraussparungen untergebracht sind, im Einklang arbeiten können, um eine axiale Gesamtauslenkung zu erzeugen, die ungefähr doppelt (2x) so groß ist wie die der jeweiligen piezoelektrischen aktiven Elemente, und eine Blockierkraft, die mit der der jeweiligen piezoelektrischen aktiven Elemente vergleichbar oder größer ist.

2. Konnektor nach Anspruch 1, wobei der Querschnitt des Konnektors eine von einer kreisförmigen Form, einer quadratischen Form, einer rechteckigen Form, einer polygonalen Form, einer Ringform oder einer polygonalen Ringform umfasst; wobei die Querschnittsform der Konnektoraussparung ungefähr die gleiche ist wie die Querschnittsform eines untergebrachten piezoelektrischen aktiven Elements und mindestens eine von einer kreisförmigen Form, einer quadratischen Form, einer rechteckigen Form, einer dreieckigen Form, einer V-Kanalform, einer T-Kanalform oder einer L-Kanalform ist.

3. Der Konnektor nach einem der vorhergehenden Ansprüche, wobei die Sockel mit dem Konnektor einteilig sind.

4. Konnektor nach einem der Ansprüche 1 oder 2, wobei die Sockel mechanisch an der zylindrischen Komponente befestigt und/oder geklebt sind.

5. Konnektor nach einem der vorhergehenden Ansprüche, wobei mindestens eine der Konnektoraussparungen zur Aufnahme der piezoelektrischen aktiven Elemente eine Ringform aufweist, wobei vorzugsweise die Konnektoraussparungen der Ringform eine Außenschale mit einer Dicke im Bereich des 0,2- bis 0,5-fachen der Breite der Konnektoraussparungen der Ringform aufweisen.

6. Konnektor nach einem der vorhergehenden Ansprüche, wobei der Konnektor mindestens eine Öffnung aufweist, um die Handhabung während der Herstellung von Betätigungselementen aus dem Konnektor zu erleichtern.

7. Der Konnektor nach einem der vorhergehenden Ansprüche, der weiterhin mindestens ein Ladepad umfasst, das mit einer Basis innerhalb mindestens einer der Konnektoraussparungen verbunden ist, oder der weiterhin mindestens eine Versteifungsplatte umfasst, die mit einer oder beiden Endflächen des Konnektors verbunden ist.

8. Konnektor nach einem der vorhergehenden Ansprüche, wobei der Konnektor weiterhin ein zentrales Konnektorloch aufweist, das durch den Konnektor verläuft.

9. Konnektor nach einem der vorhergehenden Ansprüche, wobei der Konnektor aus einem Material mit hohem Elastizitätsmodul besteht, z.B. aus einem Leichtmetall, einer technischen Keramik oder einem faserverstärkten Polymer

10. Baugruppe, umfassend mindestens einen Konnektor nach einem der Ansprüche 1 bis 9, mindestens ein oberes piezoelektrisches aktives Element und mindestens ein unteres piezoelektrisches aktives Element, wobei das mindestens eine obere piezoelektrische aktive Element aus der ersten Basis herausragt und das mindestens eine untere piezoelektrische aktive Element aus der zweiten Basis herausragt.

11. Baugruppe nach Anspruch 10, wobei jedes der oberen und unteren piezoelektrischen aktiven Elemente ein einzelnes Stück oder eine verbundene Struktur aus Piezokeramik oder piezoelektrischem Einkristall umfasst, mit entweder longitudinalem (d33) oder transversalem (d31 oder d32) Aktivierungsmodus und mit einer Gesamtquerschnittsform eines massiven Dreiecks, eines hohlen Dreiecks, eines massiven Quadrats, eines hohlen Quadrats, eines massiven Rechtecks, eines hohlen Rechtecks, eines massiven Zylinders, eines hohlen Zylinders, eines Rings, eines Pseudorings mit einer polygonalen Form, einer V-Kanal-Form, einer T-Kanal-Form oder einer L-Kanal-Form.

12. Anordnung nach Anspruch 10, wobei die piezoelektrischen aktiven Elemente mindestens eine Piezokeramik aus Blei-Zirkonat-Titanat oder ein in der Zusammensetzung modifiziertes Derivat von Blei-Zirkonat-Titanat-Piezokeramik oder einen Einkristall umfassen, der aus der Gruppe ausgewählt ist, die aus Blei-Zinkniobat-Blei-Titanat [Pb(Zn_{1/3}Nb_{2/3})O₃-PbTiOs], Blei-Magnesiumniobat-Bleititanat [Pb(Mg_{1/3}Nb_{2/3})O₃-PbTiO₃], Blei-Magnesiumniobat-Bleizirkonat-Bleititanat [Pb(Mg_{1/3}Nb_{2/3})O₃-PbZrO₃-PbTiO₃] und Blei-Indiumniobat-Bleimagnesiumniobat-Bleititanat [Pb(In_{1/2}Nb_{1/2})O₃-Pb(Mg_{1/3}Nb_{2/3})O₃-PbTiO₃] einschließlich ihrer in der Zusammensetzung modifizierten Derivate.

13. Aktuator, der mindestens eine Baugruppe nach Anspruch 10 umfasst, wobei die oberen piezoelektrischen aktiven Elemente und die unteren piezoelektrischen aktiven Elemente im Einklang arbeiten und zur gesamten axialen Auslenkung des Aktuators beitragen.

14. Aktuator nach Anspruch 13, der ferner mindestens einen Sockel, eine Grundplatte, einen Vorspannungsmechanismus, ein Gehäuse und optional ferner einen Verdrehschutzmechanismus umfasst.

15. Unterwasserprojektor mit einem Motorteil, der mindestens einen Anschluss nach einem der Ansprüche 1 bis 9 und/oder mindestens eine Baugruppe nach einem der Ansprüche 10 bis 12 aufweist.

16. Unterwasserprojektor nach Anspruch 15, der ferner mindestens eine Kopfmasse, eine Schwanzmasse, einen Vorspannungsmechanismus und ein Gehäuse umfasst.

## Revendications

1. Connecteur rigide destiné à être utilisé avec une pluralité d'éléments actifs piézoélectriques pour former un actionneur piézoélectrique à déplacement axial, à plusieurs niveaux, de grand déplacement axial global et de grandes forces de blocage, ledit connecteur comprenant :
un composant sensiblement cylindrique ayant une première base, et une seconde base dans une relation opposée et sensiblement parallèle à ladite première base ;
un ensemble de multiples évidements de connecteur équidistants et disposés de manière circonférentielle en s'étendant sensiblement à travers le connecteur à partir de ladite première base, perpendiculairement à ladite première base ; et
un ensemble de multiples évidements de connecteur équidistants et disposés de manière circonférentielle en s'étendant sensiblement à travers le connecteur à partir de ladite seconde base, perpendiculairement à ladite seconde base, lesquels s'intercalent avec l'ensemble d'évidements s'étendant à partir de la première base avec une séparation angulaire approximativement égale le long de la circonférence du connecteur ;
chaque évidement de connecteur pouvant recevoir un élément actif piézoélectrique ;
la section transversale de chaque évidement de connecteur étant sensiblement égale à celle de l'élément actif piézoélectrique qu'il peut recevoir ;
la base de chaque évidement de connecteur étant solidement reliée au corps de connecteur pour éviter un chargement en porte-à-faux pendant l'utilisation ;
la profondeur de chaque évidement de connecteur étant, de préférence, légèrement plus courte que la longueur de l'élément actif piézoélectrique qu'il peut recevoir ; et
les éléments actifs piézoélectriques, une fois reçus dans les deux ensembles d'évidements de connecteur, pouvant fonctionner à l'unisson pour produire un déplacement axial global d'approximativement deux fois (2x) celui d'éléments actifs piézoélectriques respectifs et d'une force de blocage comparable ou supérieure à celle d'éléments actifs piézoélectriques respectifs.

2. Connecteur selon la revendication 1, dans lequel la section transversale dudit connecteur comprend l'une parmi une forme circulaire, une forme carrée, une forme rectangulaire, une forme polygonale, une forme annulaire ou une forme d'anneau polygonal ; la forme de section transversale dudit évidement de connecteur étant approximativement la même que la forme de section transversale d'un élément actif piézoélectrique reçu et étant au moins l'une parmi une forme circulaire, une forme carrée, une forme rectangulaire, une forme triangulaire, une forme de canal en V, une forme de canal en T ou une forme de canal en L.

3. Connecteur selon l'une quelconque des revendications précédentes, dans lequel lesdites bases sont d'un seul tenant avec ledit connecteur.

4. Connecteur selon l'une quelconque des revendications 1 ou 2, dans lequel lesdites bases sont fixées et/ou liées mécaniquement audit composant cylindrique.

5. Connecteur selon l'une quelconque des revendications précédentes, dans lequel au moins l'un desdits évidements de connecteur destinés à recevoir lesdits éléments actifs piézoélectriques comprend une forme annulaire, de préférence lesdits évidements de connecteur de ladite forme annulaire comprenant une coque externe ayant une épaisseur se situant dans la plage allant de 0,2 à 0,5 fois la largeur desdits évidements de connecteur de ladite forme annulaire.

6. Connecteur selon l'une quelconque des revendications précédentes, ledit connecteur comprenant au moins une ouverture pour aider à la manipulation pendant la fabrication d'actionneurs à partir dudit connecteur.

7. Connecteur selon l'une quelconque des revendications précédentes, comprenant en outre au moins un tampon de charge lié à une base à l'intérieur d'au moins l'un desdits évidements de connecteur, ou comprenant en outre au moins une plaque de rigidification liée sur l'une ou les deux faces d'extrémité dudit connecteur.

8. Connecteur selon l'une quelconque des revendications précédentes, ledit connecteur comprenant en outre un trou de connecteur central traversant ledit connecteur.

9. Connecteur selon l'une quelconque des revendications précédentes, ledit connecteur étant fait d'un matériau à module d'élasticité élevé, comprenant, par exemple, un métal léger, une céramique structurale ou un polymère renforcé de fibres.

10. Assemblage comprenant au moins un connecteur selon les revendications 1 à 9, au moins un élément actif piézoélectrique supérieur et au moins un élément actif piézoélectrique inférieur, ledit au moins un élément actif piézoélectrique supérieur faisant saillie à partir de ladite première base et ledit au moins un élément actif piézoélectrique inférieur faisant saillie à partir de ladite seconde base.

11. Assemblage selon la revendication 10, dans lequel chacun desdits éléments actifs piézoélectriques supérieur et inférieur comprend une pièce individuelle ou une structure liée de monocristal piézoélectrique ou piézocéramique, de mode d'activation soit longitudinale (d₃₃) soit transversale (d₃₁ ou d₃₂) et ayant une forme de section transversale globale d'un triangle plein, d'un triangle creux, d'un carré plein, d'un carré creux, d'un rectangle plein, d'un rectangle creux, d'un cylindre plein, d'un cylindre creux, d'un anneau, d'un pseudo-anneau d'une forme polygonale, une forme de canal en V, une forme de canal en T ou une forme de canal en L.

12. Assemblage selon la revendication 10, dans lequel lesdits éléments actifs piézoélectriques comprennent au moins l'un parmi une piézocéramique de titano-zirconate de plomb ou un dérivé à composition modifiée de piézocéramique de titano-zirconate de plomb, ou un monocristal choisi parmi le groupe consistant en zinco-niobate de plomb - titanate de plomb [Pb (Zn_{1/3}Nb_{2/3})O₃-PbTiO₃], magnéso-niobate de plomb - titanate de plomb [Pb (Mg_{1/3}Nb_{2/3})O₃-PbTiO₃], magnéso-niobate de plomb - zirconate de plomb - titanate de plomb [Pb (Mg_{1/3}Nb_{2/3})O₃-PbZrO₃-PbTiO₃], et indo-niobate de plomb - magnéso-niobate de plomb - titanate de plomb [Pb(In_{1/2}Nb_{1/2})O₃-Pb(Mg_{1/3}Nb_{1/3})_{O3}-PbTiO₃], y compris leurs dérivés à composition modifiée.

13. Actionneur comprenant au moins un assemblage selon la revendication 10, dans lequel les éléments actifs piézoélectriques supérieurs et les éléments actifs piézoélectriques inférieurs travaillent à l'unisson et contribuent au déplacement axial global de l'actionneur.

14. Actionneur selon la revendication 13, comprenant en outre au moins un socle, une plaque de base, un mécanisme de précontrainte, un boîtier et, facultativement, comprenant en outre un mécanisme antitorsion.

15. Projecteur sous-marin comprenant une section moteur ayant au moins un connecteur selon les revendications 1 à 9 et/ou au moins un assemblage selon les revendications 10 à 12.

16. Projecteur sous-marin selon la revendication 15, comprenant en outre au moins un parmi une masse de tête, une masse de queue, un mécanisme de précontrainte et un boîtier.
